# EUROPÄISCHE PATENTSCHRIFT

(11) **EP 1 579 515 B1**
(45) Veröffentlichungstag und Bekanntmachung des Hinweises auf die Patenterteilung: **18.07.2007**
(21) Anmeldenummer: 03814439.0
(22) Anmeldetag: 10.07.2003
(51) Int. Cl.: H01L 41/083, H01L 41/047

(54) **Piezoaktor**
Piezo actuator
Piézo-actionneur

(30) Priorität: 20.12.2002 DE 10259949
(43) Veröffentlichungstag der Anmeldung: 28.09.2005
(73) Patentinhaber: ROBERT BOSCH GMBH, 70442 Stuttgart (DE)
(72) Erfinder: BOECKING, Friedrich, 70499 Stuttgart (DE)
(86) Internationale Anmeldenummer: PCT/DE2003/002315
(87) Internationale Veröffentlichungsnummer: WO 2004/061986

(56) Entgegenhaltungen:
- EP-A- 0 584 842
- DE-A- 10 026 005
- DE-A- 10 113 744
- DE-A- 19 753 930
- DE-C- 10 112 588

## Beschreibung

### Stand der Technik

Die Erfindung betrifft einen Piezoaktor, beispielsweise zur Betätigung eines mechanischen Bauteils wie ein Ventil oder dergleichen, nach den gattungsgemäßen Merkmalen des Hauptanspruchs.

Es ist allgemein bekannt, dass unter Ausnutzung des sogenannten Piezoeffekts ein Piezoelement aus einem Material mit einer geeigneten Kristallstruktur aufgebaut werden kann. Bei Anlage einer äußeren elektrischen Spannung erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt. Der Aufbau dieses Piezoaktors kann hier in mehreren Schichten erfolgen (Multilayer-Aktoren), wobei die Elektroden, über die die elektrische Spannung aufgebracht wird, jeweils zwischen den Schichten angeordnet werden. Solche Piezoaktoren können beispielsweise für den Antrieb von Schaltventilen bei Kraftstoffeinspritzsystemen in Kraftfahrzeugen vorgesehen werden.

Aus der DE 100 26 005 A1 ist ein solcher Piezoaktor bekannt, bei dem die jeweiligen Außenelektroden netz- oder gewebeartig auf jeweils einer Seitenfläche verteilt aufgebaut und zumindest punktweise mit den jeweiligen Innenelektroden kontaktiert sind. Die netz- oder gewebeartigen Außenelektroden sind dabei derart über den Mehrschichtaufbau der Piezolagen verlängert, dass an den Verlängerungen die Zuführung der elektrischen Spannung über entsprechende Anschlüsse erfolgt.

Aus der DE 101 13 744 A1 ist ein Vielschicht-Piezoaktor bekannt, bei dem mehrfach geschlitzte Anschlussfahnen jeweils um eine Eckkante des Piezostapels herumgebogen sind.

### Vorteile der Erfindung

Die Erfindung ist in Anspruch 1 definiert.

Der eingangs beschriebene Piezoaktor mit Außenelektroden, die netz- oder gewebeartig als sogenannte Siebelektrode aufgebracht sind und zumindest punktweise mit den jeweiligen Innenelektroden kontaktiert sind, ist erfindungsgemäß dadurch weitergebildet, dass die Kontaktierung der Innenelektroden im Eckbereich vorgenommen ist, wobei die jeweilige netz- oder gewebeartige Außenelektrode in einem vorgegebenen Bereich um die jeweilige Ecke herumgeführt und mit den jeweiligen Innenelektroden zumindest teilweise kontaktiert ist.

Erfindungsgemäß ist die jeweilige netz- oder gewebeartige Außenelektrode in Richtung des Mehrschichtaufbaus der Piezolagen weitergeführt und dort mit einem Anschlusskontakt versehen. Vorteilhaft ist dabei außerdem, wenn die Weiterführung und der Anschlusskontakt im Bereich des Querschnitts des Piezoaktors, also z.B. auf der Stirnfläche, zu liegen kommen.

Gemäß eines anderen Beispiels ist die jeweilige netz- oder gewebeartige Außenelektrode seitlich der Piezolagen weitergeführt und dort mit einem Anschlusskontakt versehen.

Die jeweilige netz- oder gewebeartige Außenelektrode ist im Bereich der Weiterführung gerollt und dann mit dem Anschlusskontakt versehen. Hierbei ist es besonders vorteilhaft, wenn die jeweilige netz- oder gewebeartige Außenelektrode und/oder der Anschlusskontakt aus Invar hergestellt sind, damit die Außenelektrode den gleichen Ausdehnungskoeffizienten wie der Piezoaktor aufweist.

Weiterhin kann die jeweilige netz- oder gewebeartige Außenelektrode und/oder der Anschlusskontakt mit den Innenelektroden jeweils verlötet oder verschweißt sein.

### Zeichnung

Ausführungsbeispiele des erfindungsgemäßen Piezoaktors werden anhand der Zeichnung erläutert. Es zeigen:
Figur 1 eine Ansicht eines Piezoaktors mit einem Mehrschichtaufbau von Lagen aus Piezokeramik und einer siebartigen Außenelektrode, die am Ende des Lagenaufbaus zur Kontaktierung weitergeführt ist,
Figur 2 eine Draufsicht auf die Stirnfläche des Piezoaktors mit den gerollten Weiterführungen der Sieb- , Außenelektrode nach der Figur 1 mit den Anschlüssen für eine elektrische Spannung,
Figur 3 eine Variante der gerollten Weiterführungen der Sieb-Außenelektrode und
Figuren 4 und 5 jeweils eine Detailansicht der angelöteten oder angeschweißten Außenelektroden.

### Beschreibung der Ausführungsbeispiele

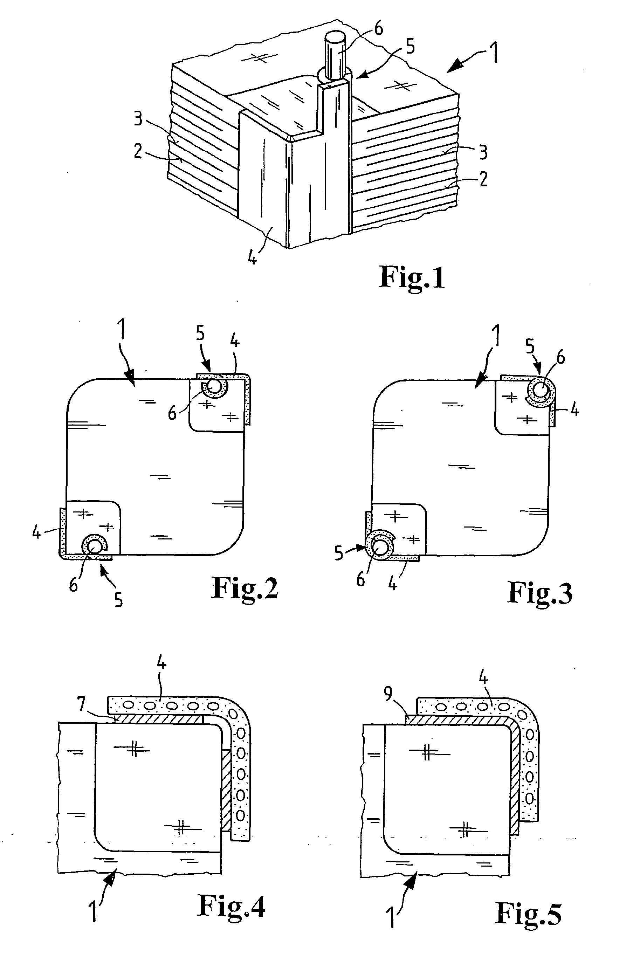

In Figur 1 ist ein Piezoaktor 1 gezeigt, der in an sich bekannter Weise aus Piezofolien eines Keramikmaterials mit einer geeigneten Kristallstruktur aufgebaut ist, so dass unter Ausnutzung des sogenannten Piezoeffekts bei Anlage einer äußeren elektrischen Spannung an Innenelektroden 2 und 3 über entsprechende elektrische Anschlüsse eine mechanische Reaktion des Piezoaktors 1 erfolgt. In der Figur 1 ist eine der wechselseitigen Kontaktierungen, hier der Innenelektroden 2, im Eckbereich des Piezoaktors 1 mit einer netz-, gewebe- oder siebartigen Außenelektrode 4 gezeigt, die in einem vorgegebenen Bereich um die jeweilige Ecke des Piezoaktors 1 herumgeführt ist.

Die Außenelektrode 4 ist dabei nach der Figur 1 mit einem Bereich 5 über die Stirnfläche des Piezoaktors 1 weitergeführt und an einer Seite des Piezoaktors 1 aufgerollt, damit ein elektrischer Anschluss 6 kontaktiert werden kann. Aus Figur 2 ist eine Draufsicht auf diese Stirnfläche zu entnehmen. Figur 3 zeigt eine Alternative der aufgerollten Weiterführung 5 im Eckbereich des Piezoaktors 1.

In Figur 4 ist im Detail gezeigt, wie die siebartige Außenelektrode 4 auf eine Grundmetallisierung 7 und 8 an den Seiten des Piezoaktors 1 oder nach Figur 5 an einer über den gesamten Eckbereich verlaufenden Grundmetallisierung 9 des Piezoaktors 1 gelötet oder geschweißt ist.

## Patentansprüche

1. Piezoaktor, mit
- einem Mehrschichtaufbau von Piezolagen und dazwischen angeordneten Innenelektroden (2,3),
- einer wechselseitigen seitlichen Kontaktierung der Innenelektroden (2,3) über Außenelektroden (4), über die eine elektrische Spannung zuführbar ist, wobei
- die jeweilige Außenelektrode (4) netz- oder gewebe- oder siebartig aufgebracht ist und zumindest punktweise mit den jeweiligen Innenelektroden (2,3) kontaktiert ist, wobei
- die Kontaktierung der Innenelektroden (2,3) im Eckbereich des Piezoaktors (1) vorgenommen ist, wobei die netz-, gewebe- oder siebartige Außenelektrode (4) in einem vorgegebenen Bereich um die jeweilige Ecke herumgeführt und mit den jeweiligen Innenelektroden (2,3) zumindest teilweise kontaktiert ist und
- die netz-, gewebe- oder siebartige Außenelektrode (4) in Richtung des Mehrschichtaufbaus der Piezolagen weitergeführt ist (5) und dort mit einem Anschlusskontakt (6) versehbar ist, wobei
- die jeweilige netz-, gewebe- oder siebartige Außenelektrode (4) im Bereich der Weiterführung (5) gerollt und mit einem Anschlusskontakt (6) versehen ist.

2. Piezoaktor nach Anspruch 1, **dadurch gekennzeichnet, dass**
- die Weiterführung (5) und der Anschlusskontakt (6) im Bereich des Querschnitts des Piezoaktors (1) zu liegen kommen.

3. Piezoaktor nach einem der vorhergehenden Ansprüche, **dadurch gekennzeichnet, dass**
- die jeweilige netz-, gewebe- oder siebartige Außenelektrode (4) und/oder der Anschlusskontakt (6) aus Invar hergestellt sind.

4. Piezoaktor nach einem der vorhergehenden Ansprüche, **dadurch gekennzeichnet, dass**
- die jeweilige netz-, gewebe- oder siebartige Außenelektrode (4) und/oder der Anschlusskontakt (6) mit den Innenelektroden (2,3) jeweils verlötet sind.

5. Piezoaktor nach einem der Ansprüche 1 bis 3, **dadurch gekennzeichnet, dass**
- die jeweilige netz-, gewebe- oder siebartige Außenelektrode (4) und/oder der Anschlusskontakt (5) mit den Innenelektroden (2,3) jeweils verschweißt sind.

## Claims

1. Piezo actuator, having
- a multilayer structure of piezo layers and inner electrodes (2, 3) arranged between them,
- lateral contact-connection between the inner electrodes (2, 3) on alternate sides via outer electrodes (4), via which an electric voltage can be supplied, wherein
- the respective outer electrode (4) is applied in the style of a mesh or woven fabric or screen and is contact-connected to the respective inner electrodes (2, 3) at least in punctiform fashion, wherein
- the contact-connection of the inner electrodes (2, 3) is realized in the corner region of the piezo actuator (1), with the mesh-like, woven-fabric-like or screen-like outer electrode (4) being guided around the respective corner in a predetermined region and at least partially contact-connected to the respective inner electrodes (2, 3), and
- the mesh-like, woven-fabric-like or screen-like outer electrode (4) is continued (5) in the direction of the multilayer structure of the piezo layers, where it can be provided with a terminal contact (6), wherein
- the respective mesh-like, woven-fabric-like or screen-like outer electrode (4), in the region of the continuation (5), is rolled up and provided with a terminal contact (6).

2. Piezo actuator according to Claim 1, **characterized in that**
- the continuation (5) and the terminal contact (6) come to lie in the region of the cross section of the piezo actuator (1).

3. Piezo actuator according to one of the preceding claims, **characterized in that**
- the respective mesh-like, woven-fabric-like or screen-like outer electrode (4) and/or the terminal contact (6) are made from Invar.

4. Piezo actuator according to one of the preceding claims, **characterized in that**
- the respective mesh-like, woven-fabric-like or screen-like outer electrode (4) and/or the terminal contact (6) are in each case soldered to the inner electrodes (2, 3).

5. Piezo actuator according to one of Claims 1 to 3, **characterized in that**
- the respective mesh-like, woven-fabric-like or screen-like outer electrode (4) and/or the terminal contact (6) are in each case welded to the inner electrodes (2, 3).

## Revendications

1. Actionneur piézoélectrique, comprenant :
- une structure multicouche de couches piézoélectriques et d'électrodes internes (2, 3) disposées entre celles-ci,
- une mise en contact latérale alternée des électrodes internes (2, 3) par des électrodes externes (4) appliquant une tension électrique,
- chaque électrode externe (4) étant posée à la manière d'un réseau ou d'un tissu ou d'un treillis et mise en contact au moins ponctuellement avec les électrodes internes respectives (2, 3),
- la mise en contact des électrodes internes (2, 3) se faisant dans la zone d'angle de l'actionneur piézoélectrique (1), l'électrode externe (4) en forme de réseau ou de tissu ou de treillis étant placée autour de l'angle respectif dans une zone prédéterminée et est mise en contact au moins partiellement avec les électrodes internes respectives (2, 3), et
- l'électrode externe (4) en forme de réseau ou de tissu ou de treillis étant prolongée (5) en direction de la structure multicouche des couches piézoélectriques et munie d'un contact de raccordement (6), dans lequel
- l'électrode externe respective (4) en forme de réseau ou de tissu ou de treillis est enroulée dans la zone du prolongement (5) et y est munie d'un contact de raccordement (6).

2. Actionneur piézoélectrique selon la revendication 1,
**caractérisé en ce que**
le prolongement (5) et le contact de raccordement (6) viennent se placer dans la zone de la section transversale de l'actionneur piézoélectrique (1).

3. Actionneur piézoélectrique selon l'une quelconque des revendications précédentes,
**caractérisé en ce que**
l'électrode externe respective (4) en forme de réseau ou de tissu ou de treillis et/ ou le contact de raccordement (6) sont fabriqués en Invar.

4. Actionneur piézoélectrique selon l'une quelconque des revendications précédentes,
**caractérisé en ce que**
l'électrode externe respective (4) en forme de réseau ou de tissu ou de treillis et/ou le contact de raccordement (6) sont chaque fois brasés avec les électrodes internes (2, 3).

5. Actionneur piézoélectrique selon l'une quelconque des revendications 1 à 3,
**caractérisé en ce que**
l'électrode externe respective (4) en forme de réseau ou de tissu ou de treillis et/ou le contact de raccordement (6) sont chaque fois soudés avec les électrodes internes (2, 3).
